Europäisches Patentamt

European Patent Office

Office européen des brevets

(11) Publication number: **0 503 761 A1**

## EUROPEAN PATENT APPLICATION

(21) Application number: **92300973.2**

(22) Date of filing: **05.02.92**

(51) Int. Cl.⁵: **H04B 1/04**, H03C 1/60, H03F 3/217

(30) Priority: **14.03.91 GB 9105380**

(43) Date of publication of application:
**16.09.92 Bulletin 92/38**

(84) Designated Contracting States:
**BE CH DE DK ES FR IT LI NL**

(71) Applicant: **GEC-Marconi Limited**
**The Grove Warren Lane**
**Stanmore Middlesex HA7 4LY(GB)**

(72) Inventor: **Pike, Tudor David**
**6 Granger Avenue**
**Maldon, Essex, CM9 6AN(GB)**

(74) Representative: **Waters, Jeffrey et al**
**GEC Patent Department, GEC Marconi**
**Limited, West Hanningfield Road**
**Great Baddow, Chelmsford, Essex CM2**
**8HN(GB)**

(54) **Power amplifying means for r.f. signals.**

(57) A known pulse width modulator transmitter amplifies a constant amplitude r.f. signal from drive (7) in dependence on the level of supply voltage to the power amplifier (2) which in turn depends on the amplitude of an audio input which controls a pulse width modulator (1). However the transmitter is convertible to a single side band mode because a signal derived from the envelope of an amplitude modulated drive waveform from drive (7) is predistorted in compensation network (9) and so controls the pulse width modulator (1) as to maintain the supply voltage of the power amplifier, now operating in a linear mode, substantially constant despite the now varying input current requirements of the amplifier.

This invention relates to power amplifying means for r.f. signals.

Pulse width modulation has been used in power amplifying means of broadcast transmitters to provide an improvement of operating efficiency of the transmitter, because the switched mode of operation of the modulator is inherently more efficient than Class B operation of the modulator. A modulator of the switched mode type is interposed between a supply source and a low pass filter connected to an r.f. power amplifier. The power amplifier amplifies an r.f. drive of constant amplitude to an extent dependent on the variable level of the supply voltage of the power amplifier, to provide high level double side band amplitude modulation, the level of the supply voltage being dependent on the widths of the pulses leaving the pulse width modulator.

The invention provides power amplifying means for r.f. signals, comprising a pulse modulator connected to an r.f. power amplifier via a low pass filter to permit control of the supply voltage to the power amplifier for operation in a high level pulse modulation mode, wherein, in order to permit operation in a low level single sideband amplitude modulation mode, a signal derived from the envelope of a single sideband modulated signal may so control the pulse modulator that the supply voltage of the r.f. power amplifier is maintained substantially constant.

The current drawn by the r.f. amplifier in the single sideband (s.s.b) modulation mode varies with the amplitude of the low level s.s.b. modulated r.f. signal, but the substantially constant supply voltage necessary for this mode is nevertheless maintained by controlling the pulse modulator by means of a signal derived from the envelope of the s.s.b. amplitude modulated r.f. signal. This makes it possible to convert the power amplifying means from operation in a high level pulse modulation mode to operation in a low level s.s.b. modulation mode.

In the known transmitters employing pulse width modulation, the output voltage swing at the antenna is proportional to the mean power amplifier supply voltage. The ratio of the supply voltage swing to the supply current swing is approximately constant, and hence the filter behaves as if it is terminated in a reasonably constant impedance. While this is still true in the power amplifying means of the invention when operating in the high level modulation mode, in the low level s.s.b. amplitude modulation mode, the r.f. power amplifier behaves as a time varying impedance and thus the filter is no longer terminated in its correct impedance.

Advantageously, the power amplifying means includes compensation means which uses the envelope of the amplitude modulated s.s.b. signal so that the control signal fed to the pulse modulator compensates for the impedance mismatch between the filter and the power amplifier.

Preferably, the compensation means is arranged to apply a signal to the modulator which represents the inverse of the short circuit load response of the filter. The reason for this is that, if the control signal is functioning correctly to maintain the power amplifier supply voltage constant, the filter must be effectively operating into a short circuit as far as its input signal is concerned, since a finite input voltage to the filter produces no output voltage i.e. no disturbance of the power amplifier supply voltage, but significant operating current. Hence, to compensate for this effective short circuit load response, the compensation means applies a signal to the modulator which represents the inverse function.

The power amplifying means is particularly suitable for use in the L.F. (30 to 300KHz), M.F. (300 to 3000KHz) and H.F. (3 to 30MHz) ranges.

Power amplifying means for a high power broadcast transmitter, constructed in accordance with the invention, will now be described, by way of example, with reference to the accompanying drawings, in which:

Figure 1 is a block diagram of the transmitter operating in the pulse width modulated mode;

Figure 2 is a block diagram of the transmitter operating in an SSB mode;

Figure 3 is a circuit diagram of the pulse width modulation filter;

Figure 4 is a diagram of an equivalent circuit to that of Figure 3 when terminated in the r.f. power amplifier configured for s.s.b. mode;

Figure 5 shows the phase and relative mutual conductance of the short circuit pulse width modulation filter;

Figure 6 is a circuit diagram of the compensation network; and

Figure 7 shows the phase and relative gain of the compensation network in conjunction with an effective phase advance due to the r.f. drive.

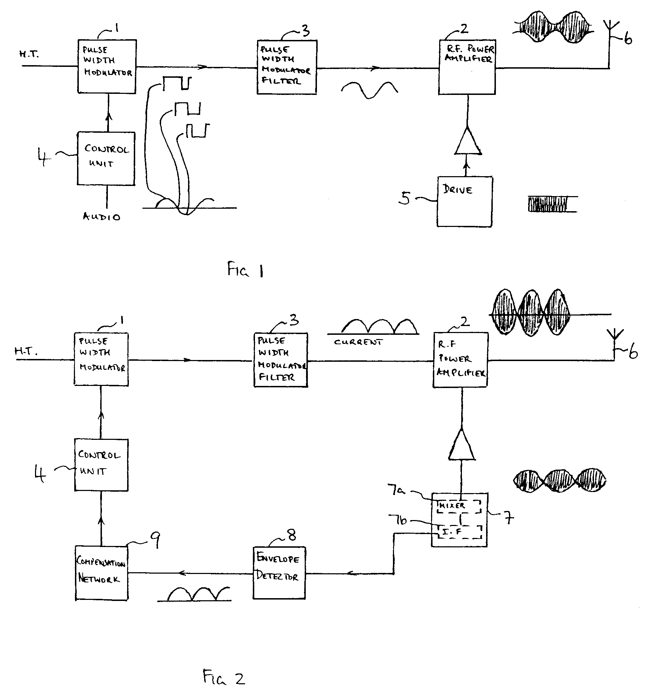

Referring to Figure 1, the power amplifying means comprises a pulse width modulator 1 which feeds pulses of an HT supply e.g. 30k.v. (not shown) to an r.f. power amplifier 2 via a filter 3 in accordance with an audio modulating signal which sends a control signal to the modulator from a control unit 4. The control signal causes the width of the pulses to vary in accordance with the audio input. An audio tone will produce a train of output pulses from the modulator of sinusoidally varying widths, the widest pulses corresponding to the peaks of the audio tone, the narrowest pulses corresponding to the troughs of the audio tone, and the zero crossings of the audio tone corresponding to pulses of median width.

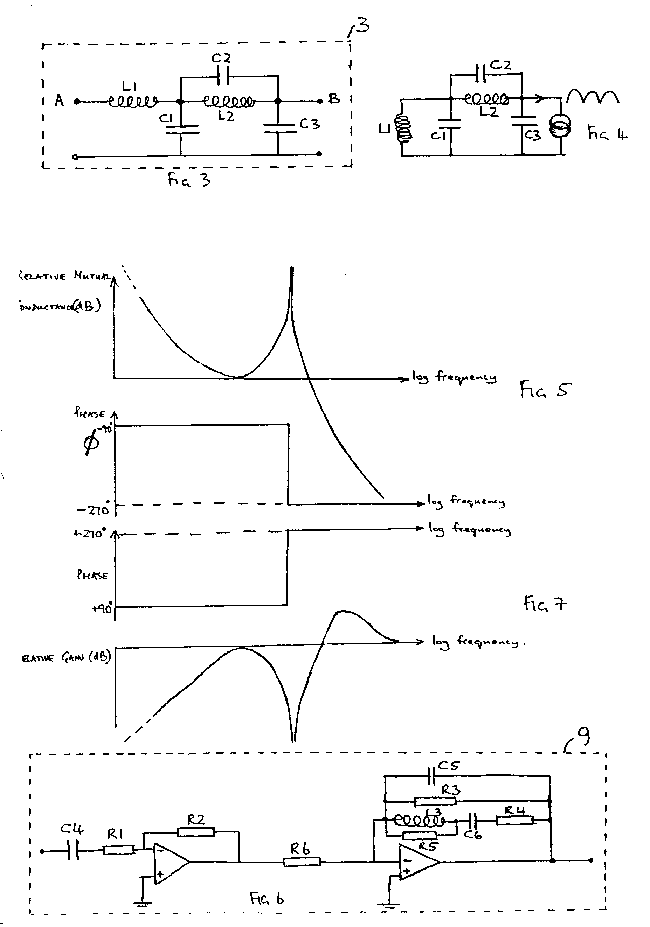

The switching frequency, which may be in the region of from 55KHz to 60KHz, is filtered from the train of HT pulses by means of the pulse width modulator filter 3, which has the form shown in Figure 3, and rolls off at around 8KHz to attenuate noise, harmonics of the switching frequency, and FM components produced by the dynamically varying edge of the pulses. The filter consists of section L1, C1 in series with section L2 in parallel with C2, C3.

The output of the filter is an HT voltage varying in accordance with the audio signal. This high level modulating signal acts as the anode high voltage level (e.g. of a tetrode) of the power amplifier 2, which is configured in Class C. The amplifier amplifies an r.f. drive 5 of constant amplitude and modulates it with the amplitude of the varying HT level (and hence the amplitude of the audio input) to produce an amplitude modulated double sideband output signal, which is launched from an antenna 6.

In accordance with the invention, the transmitter is capable of modification from the high level pulse width modulation mode, which is known in itself, to provide the option of operation in s.s.b. amplitude modulated mode. To this end, the circuit of Figure 1 is modified as follows, like parts being given like reference numerals.

In its s.s.b. mode of operation, the r.f. power amplifier 2 is reconfigured to operate in Class B (or Class AB) to approximate to a linear amplifier, and the r.f. anode supply voltage is held substantially constant by means which will be described later, in order to amplify in a linear fashion a low level s.s.b. drive signal (the carrier being modulated by an audio input) feeding the r.f. power amplifier. The illustrated drive waveform is a typical s.s.b. test signal consisting of the vector sum of two r.f. tones of equal amplitude, the resulting envelope shape corresponding to the difference between the tone frequencies.

It will be apparent that the control unit 4, pulse width modulator 1 and its associated filter 3 are not needed to provide a (high level) modulating signal, since a low level modulating signal is used. These components nevertheless cannot be dispensed with since the r.f. power amplifier 2 requires a mean supply level generally less than half the HT supply, and there is no satisfactory way of providing such a level except by using these components.

When the transmitter is operating in its high level pulse width modulated mode, the r.f. power amplifier behaves as if it is a reasonably constant impedance (as the ratio of the input voltage swing to supply current swing is constant), and the filter 3 is therefore terminated in its correct impedance.

However, when the transmitter is now operating in the s.s.b. the r.f. power amplifier must draw from the filter a current which rises and falls with the rise and fall of the envelope of the amplitude s.s.b. output, because the anode supply voltage now remains substantially constant (i.e. the voltage at point A in Figure 3 must be increased or decreased so that the current disturbances at B exactly match the current drawn by the s.s.b. configured r.f. stage for no change in anode supply voltage). The filter behaves like a frequency varying supply source impedance whose characteristics are identical to those representing the output impedance of the filter when its input impedance is terminated in a fixed low impedance (because the modulator has a low output impedance at signal frequencies). The equivalent circuit representing the input to the amplifier, with the amplifier being represented as a current generator, can thus be represented by Figure 4. It turns out that this circuit produces two significant shunt resonances at audio frequencies, and this would greatly restrict the usable modulation bandwidth.

To overcome this problem, it was considered to modify and/or switch the high power components, but this a relatively complex operation with disadvantages. Instead, in accordance with the invention, a low power electronic solution was proposed whereby a signal derived from the envelope of the drive waveform (produced by envelope detector 8) is, after passing through compensation network 9, used to control the width of the pulses from the HT supply via the control unit 4. The width of the pulses can be modified in step with the time varying demand for increased or decreased current from the filter to enable the anode supply to remain substantially constant.

The characteristic required for the filter 3 can be appreciated by realising that, when the control signal is such as to produce pulses of such a width as to maintain constant anode supply voltage, the input signal voltage to the filter at A (Figure 3) produces no signal voltage (i.e. no disturbance on the amplifier supply voltage) at the output B, but a significant output current. This is equivalent to operating the filter into a short circuit. To compensate for the effect that the filter would have on the pulses from the modulator, the compensation network 9 predistorts the envelope of the drive waveform by imposing on it a transfer function which is the inverse of the short circuit load response of the filter 3.

With the particular circuit illustrated, the short circuit load response of the filter is shown in Figure 5, and its inverse in Figure 7. To simplify the compensation network given that a phase lead of either 90° or 270° is required, the envelope detector 6 takes its signal from an i.f. stage 7a of the drive 7. This leads the actual drive waveform applied to the power amplifier 2, since the mixer 7b in which the i.f. is mixed to the required carrier frequency, incorporates filters which imparts a delay of the order of 50 microseconds.

The compensation network of Figure 6 produces, in conjunction with the effective advance due to the r.f. drive, the required characteristics of Figure 7. The circuit provides for compensation over the range 200Hz to 11KHz by approximating the inverse of the short circuit load forward mutual conductance (.gm) of the modulator and p.w.m. filter within this range. With reference to Figure 6, time constant $T_1$ (due capacitor C4 and resistor R1) dominates the low frequency response below the first peak. Resonance $fr_1$ (due to the parallel connection of C5 and R3 and the branch containing R4, C6 and L3 in parallel with R5) dominates the response near and at the compensation for the p.w.m. forward series resonance. Damped resonance $fr_2$ (due to the branch containing R4, C6 and L3 in parallel with R5) controls the out of band gain roll off, phase distortion being compensated for by the effective advance due to the r.f. drive.

The short circuit equivalence simplifies the transfer characteristics of the filter and hence its inverse. The two shunt resonances are effectively suppressed, and a single series resonance is created at about 8KHz. The delay of the SSB drive signal relative to that used to derive the envelope signal for the compensator avoids the drawback of increasing out of band gain resulting from the necessary phase advance of the compensated pulse width modulated input signal.

It should be added that it is not necessary for the supply voltage of the r.f. power amplifier to be maintained absolutely constant. It may in fact increase very slightly in step with the current increases which the amplifier needs to draw from the filter 3 in step with the drive waveform.

A power amplifier means of the invention is thus operable in high level pulse width modulated form, but may readily be converted to low level SSB operation. The amplifier could operate in forms of pulse modulation other than pulse width modulation e.g. pulse position or pulse amplitude. Equally, other forms of filter than that shown in Figure 3 may be used, and the circuit required to produce the inverse of the short circuit load response will accordingly be different.

## Claims

1.  Power amplifying means for r.f. signals, comprising a pulse modulator connected to an r.f. power amplifier via a low pass filter to permit control of the supply voltage to the power amplifier for operation in a high level pulse modulation mode, wherein, in order to permit operation in a low level single sideband amplitude modulation mode, a signal derived from the envelope of a single sideband modulated signal may so control the pulse modulator that the supply voltage of the r.f. power amplifier is maintained substantially constant.

2.  Power amplifying means as claimed in claim 1, including compensation means arranged to use the envelope of the s.s.b. signal so that the control signal fed to the pulse modulator compensates for the impedance mismatch between the filter and the power amplifier.

3.  Power amplifying means as claimed in claim 2, in which the compensation means is arranged to apply to the envelope the inverse of the short circuit load response of the filter.

4.  Power amplifying means as claimed in claim 2 or claim 3, in which the envelope of the s.s.b. signal used for controlling the pulse modulator leads the envelope of the low level drive waveform.

5.  Power amplifying means as claimed in any one of claims 1 to 4, in which the pulse modulator is a pulse width modulator.

6.  A broadcast transmitter incorporating power amplifying means as claimed in any one of claims 1 to 6.

Fig 1

Fig 2

Fig 3

Fig 4

Fig 5

Fig 7

Fig 6

European Patent Office

**EUROPEAN SEARCH REPORT**

Application Number

EP 92 30 0973

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 112 410 (BBC AKTIENGESELLSCHAFT BROWN, BOVERI & CIE) * figure 1; abstract; page 5, lines 9-19 * --- | 1,4 | H 04 B 1/04 H 03 C 1/60 H 03 F 3/217 |
| A | PATENT ABSTRACTS OF JAPAN vol. 10, no. 285 (E-441)(2341), 27 September 1986; & JP - A - 61105101 (KOKUSAI ELECTRIC) 23.05.1986 --- | 1 | |
| A | EP-A-0 054 981 (BBC AKTIENGESELLSCHAFT BROWN, BOVERI & CIE) * figure 1; abstract * --- | | |
| A | US-A-4 176 319 (KAHN) * figure 1; abstract * ----- | | |

TECHNICAL FIELDS SEARCHED (Int. Cl.5)

H 04 B
H 03 C
H 03 F

The present search report has been drawn up for all claims

| Place of search | Date of completion of the search | Examiner |
|---|---|---|
| BERLIN | 13-05-1992 | BREUSING J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

  & : member of the same patent family, corresponding document

EPO FORM 1503 03.82 (P0401)